Europäisches Patentamt

European Patent Office

Office européen des brevets

(11) Numéro de publication: **0 151 067**
A2

## DEMANDE DE BREVET EUROPEEN

(21) Numéro de dépôt: 85400092.4

(22) Date de dépôt: 18.01.85

(51) Int. Cl.⁴: **H 03 H 3/02**, H 03 H 9/19

(30) Priorité: 27.01.84 FR 8401295

(43) Date de publication de la demande: 07.08.85
Bulletin 85/32

(84) Etats contractants désignés: CH DE GB LI NL

(71) Demandeur: COMPAGNIE D'ELECTRONIQUE ET DE
PIEZO-ELECTRICITE - C.E.P.E., 44, rue de la Glacière,
F-95100 Argenteuil (FR)

(72) Inventeur: Debaisieux, André, THOMSON-CSF
SCPI 173, bld Haussmann, F-75379 Paris Cedex 08 (FR)
Inventeur: Aubry, Jean-Pierre, THOMSON-CSF
SCPI 173, bld Haussmann, F-75379 Paris Cedex 08 (FR)

(74) Mandataire: Ruellan-Lemonnier, Brigitte et al,
THOMSON-CSF SCPI 173, boulevard Haussmann,
F-75379 Paris Cedex 08 (FR)

(54) Procédé de fabrication d'un résonateur auto-suspendu.

(57) La présente invention concerne un procédé de fabrication d'un résonateur auto-suspendu à partir d'une lame de quartz, dans lequel on découpe une pluralité de fentes (8, 9, 10), séparant la zone active (1) de la lame de sa couronne périphérique (5), reliées entre elles par une pluralité de ponts (4, 6, 7). Selon l'invention, on réalise ensuite un biseau sur le bord intérieur des fentes (8, 9, 10) de l'une au moins des faces de la lame, de manière à casser l'arête correspondante de la zone active (1) de la lame.

ACTORUM AG

0151067

*1*

# PROCEDE DE FABRICATION D'UN RESONATEUR
## AUTO-SUSPENDU

La présente invention concerne un procédé de fabrication d'un résonateur auto-suspendu à partir d'une lame de quartz, procédé dans lequel on découpe une pluralité de fentes séparant la zone active de la lame de sa couronne périphérique, reliées entre elles par une pluralité de ponts. Des résonateurs auto-suspendus de ce type ont été décrits dans les demandes françaises 83 15 652 intitulée "RESONATEUR AUTO-SUSPENDU DE HAUTE SURTENSION", 83 15 653 intitulée "RESONATEUR DE FAIBLE SENSIBILITE AUX ACCELERATIONS" et 83 15 654 intitulée "RESONATEUR PIEZO-ELECTRIQUE POUR ENVIRONNEMENT SEVERE" déposées le 30 septembre 1983 au nom de la Demanderesse. Les fentes réalisées sur cette lame de quartz permettent d'obtenir un découplage mécanique entre la partie active de la lame de la couronne périphérique à laquelle sont fixés les poteaux de maintien de la lame de quartz sur l'embase du résonateur.

On a constaté que les résonateurs à quartz à onde de volume présentent des limitations essentiellement dues aux conditions aux limites imparfaites.

Le procédé selon l'invention permet d'améliorer sensiblement les conditions aux limites de tels résonateurs. Il est caractérisé en ce que l'on réalise un biseau sur le bord intérieur des fentes de l'une au moins des faces de la lame, de manière à casser l'arête correspondante de la zone active de ladite lame. De préférence, ledit biseau est réalisé par attaque chimique, par immersion de la lame dans un bain acide après dépôt d'une couche de protection dans les zones qui ne doivent pas être attaquées. Ce biseau peut également être réalisé par gravure ultra-sonore ou par usinage mécanique.

De préférence, ce biseau sera sensiblement plan, l'angle $\alpha$ entre le plan du biseau et l'axe perpendiculaire au plan de la lame étant sensiblement compris entre 45° et 80°.

L'invention sera mieux comprise à l'aide des exemples de réalisation suivants, donnés à titre non limitatif, conjointement avec les figures qui représentent :

- la figure 1, une vue d'ensemble d'un résonateur réalisé selon le procédé selon l'invention,

- la figure 2, une vue schématique de la réalisation du biseau selon le procédé de l'invention.

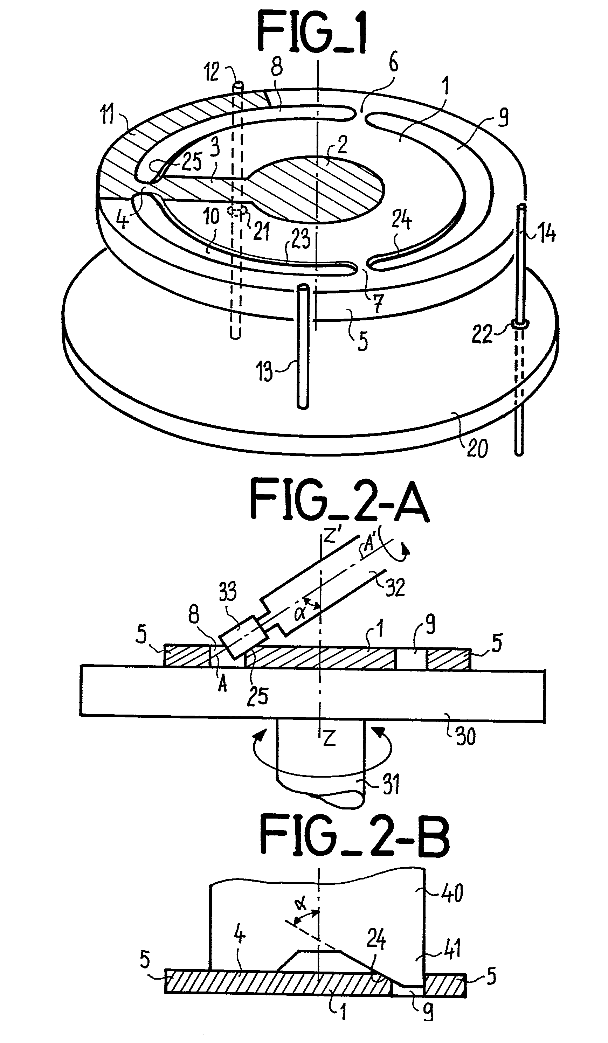

Sur la figure 1, est représentée une vue d'un résonateur obtenu à partir d'une lame de quartz fabriquée selon le procédé de l'invention. La partie centrale 1 de cette lame ou partie active est recouverte en son centre d'une électrode métallisée adhérente 2 se prolongeant par une zone de prolongement 3 jusqu'à un pont 4 de matériau piézo-électrique reliant également la zone de prolongement 3 à la couronne périphérique 5 de la lame piézo-électrique. Cette couronne périphérique 5 est métallisée sur sa partie supérieure 11 au moins jusqu'au poteau de connexion électrique et de maintien 12 de la lame. Ce poteau 12 traverse l'embase 20 à travers une perle de verre isolante 21. Dans l'exemple représenté sur la figure 1, la lame piézo-électrique comporte trois ponts 4, 6 et 7 reliant la zone active 1 à la couronne périphérique 5. Les ouvertures 8, 9 et 10 sous forme de rainures traversant de part en part la lame piézo-électrique séparent respectivement les ponts 4 et 6, 6 et 7, 7 et 4. Bien entendu, cette lame possède une électrode identique sur sa face inférieure (non représentée sur la figure) se prolongeant par une zone de prolongement telle que 3 traversant l'un des ponts 6 ou 7 de manière à être connectée à une zone métallisée sur la face inférieure de la zone périphérique 5. Cette zone métallisée inférieure sur la couronne périphérique 5 est reliée au poteau de maintien des connexions électriques 14 traversant l'embase 20 à travers la perle de verre 22, tandis qu'un poteau de maintien 13 assure la fixation mécanique de la lame en un troisième point, ce poteau 13 étant solidaire de l'embase.

En pratique, on utilisera généralement deux ponts mais de préférence quatre ce qui permet de n'utiliser que deux poteaux de maintien ayant également une fonction de connexion électrique, poteaux disposés sensiblement à mi-distance entre deux ponts successifs à l'opposé l'un de l'autre par rapport au centre de la lame piézo-électrique (de forme cylindrique sur la figure 1). Pour plus de détails sur la disposition des ponts et des fentes par rapport aux poteaux, on pourra se reporter aux demandes de brevets citées plus hauts, dont le contenu est incorporé au texte de la présente demande.

Sur cette figure 1, on remarque les biseaux 23, 24 et 25 réalisés respectivement sur le bord intérieur des fentes 10, 9 et 8 de la face supérieure de la lame, de manière à casser l'arête correspondante de la zone active 1 de la lame au niveau desdites fentes. Bien entendu, ladite lame comportera, de préférence, des biseaux généralement identiques sur les bords correspondants des fentes situés sur la face inférieure de la lame 1.

Le procédé le plus aisé pour réaliser ces biseaux consiste à déposer une résine de protection telle qu'un polymère insensible aux attaques acides sur l'ensemble de la lame de quartz, avant sa métallisation, de manière à protéger cette lame sauf dans les zones destinées à être attaquer chimiquement par le bain acide. La durée de l'immersion permet de contrôler la profondeur de la gravure. Celle-ci sera déterminée par les extrémités des zones recouvertes de résine et la sensible planéité du biseau obtenue par une immersion de durée adéquate. Par de simples manipulations de routine, l'homme de métier déterminera ces durées sans difficulté.

La figure 2 représente deux variantes de réalisation du biseau selon l'invention. Sur la figure 2a, est représenté schématiquement le procédé de rodage mécanique du bord interne des fentes tel qu'expliqué ci-dessus. Pour cela, on utilise une table goniométrique 30 en rotation autour de son axe 31, et une meule 32 dont l'axe de rotation AA' fait un angle α avec l'axe vertical ZZ' perpendiculaire à la face inférieure plane de la lame de quartz. La tête 33 de la meule amenée à rotation réalise le biseau 25 par rodage mécanique, la table goniométrique 30 tournant sur elle-même. Bien entendu, au

4

niveau des ponts, ladite meule 32 est soulevée puis, après rotation de la table, réintroduite dans la fente suivante.

La figure 2b représente une variante d'usinage ultra-sonore des biseaux sur la lame de quartz selon le procédé de l'invention. Comme dans les figures précédentes, les mêmes références ont la même signification. On utilise pour cela un outil de coupe ultra-sonore 40 ayant un profil interne faisant un angle α avec l'axe ZZ', lui donnant ainsi une forme sensiblement conique. La partie inférieure 41 de cet outil 40 permet ainsi la création du biseau 24 par pénétration partielle dans ladite fente, et rotation de l'outil dans la fente. L'outil est, bien entendu, soulevé pour passer à la fente suivante.

EXEMPLES COMPARATIFS :

On réalise, toutes choses égales par ailleurs, deux lames de quartz 5 MHz SCP/3 comportant quatre ponts répartis à 90° selon les axes XX' et YY'. Ces lames de quartz ont un diamètre de 24 mm, une zone active de 15 mm, une face convexe de rayon RC = 300 mm dont les métallisations d'électrodes ont un diamètre de 8 mm.

La lame sans biseau a une résistance motionnelle de 80 Ohms et un coefficient de qualité Q de $2 \times 10^6$.

La lame munie d'un biseau à 60° a une résistance motionnelle de 67 Ohms pour un coefficient Q de $2,5 \times 10^6$.

On constate donc une nette amélioration de la résistance motionnelle et du coefficient Q de la lame.

On note que l'on obtient sensiblement les mêmes résultats dans toute la gamme 45°-80°.

On a également noté que l'enfoncement du biseau, c'est-à-dire la distance de sa base au sommet de la rainure pouvait varier entre 10% et 50% de la profondeur de la fente entre les ponts, tout en obtenant la même amélioration des résultats.

# REVENDICATIONS

1. Procédé de fabrication d'un résonateur auto-suspendu à partir d'une lame de quartz, dans lequel on découpe une pluralité de fentes (8, 9, 10), séparant la zone active (1) de la lame de sa couronne périphérique (5), reliées entre elles par une pluralité de ponts (4, 6, 7), caractérisé en ce que l'on réalise ensuite un biseau sur le bord intérieur des fentes (8, 9, 10) de l'une au moins des faces de la lame, de manière à casser l'arête correspondante de la zone active (1) de la lame.

2. Procédé selon la revendication 1, caractérisé en ce que ledit biseau est réalisé par attaque chimique, par immersion de la lame dans un bain acide, après dépôt d'une couche de protection dans les zones qui ne doivent pas être attaquées.

3. Procédé selon la revendication 1, caractérisé en ce que ledit biseau est réalisé par gravure ultra-sonore.

4. Procédé selon la revendication 1, caractérisé en ce que ledit biseau est réalisé par usinage mécanique.

5. Procédé selon l'une des revendications 3 ou 4, caractérisé en ce que l'angle $\alpha$ entre le plan du biseau et l'axe perpendiculaire au plan de la lame est compris entre 45° et 80°.

6. Procédé selon l'une des revendications 1 à 5, caractérisé en ce que la profondeur du biseau peut varier entre 10% et 50% de la profondeur de la fente (8, 9, 10).

# FIG_1

# FIG_2-A

# FIG_2-B